# EUROPEAN PATENT SPECIFICATION

(11) **EP 4 166 245 B1**
(45) Date of publication and mention of the grant of the patent: **28.02.2024**
(21) Application number: 22164066.7
(22) Date of filing: 24.03.2022
(51) Int. Cl.: B06B 1/04, B06B 3/00, B06B 1/08, B81C 99/00

(54) **SYSTEM FOR THE FORMATION OF MICROSTRUCTURES IN POLYMERIC MATERIALS**
SYSTEM ZUM BILDEN VON MIKROSTRUKTUREN IN POLYMEREN MATERIALIEN
SYSTÈME POUR LA FORMATION DE MICROSTRUCTURES DANS DES MATÉRIAUX POLYMÈRES

(30) Priority: 13.10.2021 LT 2021551
(43) Date of publication of application: 19.04.2023
(73) Proprietor: Kaunas University of Technology, 44249 Kaunas (LT)
(72) Inventor: Janusas, Giedrius, LT-54453 Kaunas (LT); Bubulis, Algimantas, LT-52177 Kaunas (LT); Palevicius, Arvydas, LT-44146 Kaunas (LT); Ostasevicius, Vytautas, LT-44151 Kaunas (LT); Jurenas, Vytautas, LT-44151 Kaunas (LT); Ciganas, Justas, LT-80162 Siauliai (LT)
(74) Representative: Klimaitiene, Otilija

(56) References cited:
- CN-B- 107 931 079
- US-A1- 2006 101 919
- LI YAFANG ET AL: "High-Frequency Output Characteristics of Giant Magnetostrictive Transducer", IEEE TRANSACTIONS ON MAGNETICS, IEEE, USA, vol. 55, no. 6, 1 June 2019 (2019-06-01), pages 1-5, XP011724387, ISSN: 0018-9464, DOI: 10.1109/TMAG.2019.2910854 [retrieved on 2019-05-15]
- SCHULZE V ET AL: "Surface modification by machine hammer peening and burnishing", CIRP ANNALS, ELSEVIER BV, NL, CH, FR, vol. 65, no. 2, 5 August 2016 (2016-08-05) , pages 809-832, XP029690808, ISSN: 0007-8506, DOI: 10.1016/J.CIRP.2016.05.005

## Description

### FIELD OF THE INVENTION

The invention belongs to the field of materials science. More specifically, to the technology for the production of microstructures - the development of elements of microelectromechanical systems (MEMS).

### THE PRIOR ARTS

Currently, a method and an apparatus for the development of a MEMS sensor using thermal and mechanical pressure and high frequency oscillation excitation for this purpose is known (Amer Sodah, 2020, Development and analysis of microelectromechanical sensors for human health care monitoring. Doctoral dissertation, 106 p., p. 62). The specified device uses tightly interconnected piezoceramic rings with electrodes connected to a high frequency generator for excitation of oscillations. The piezoceramic rings are mounted in the structure of an electromechanical transducer (sonotrode), the working part of which has a heat-emitting source at the end. According to the established control program and in a certain time sequence, the microstructure is formed by pressing the sonotrode into the forming material, controlling the temperature regime and subjecting high frequency oscillations. The disadvantage of the specified prototype is that the dedicated device uses piezoceramic elements for excitation of oscillations, the operating temperature of which cannot exceed 180 °C, because at higher temperatures the piezoceramic elements depolarize, thus losing the piezoeffect. Adapting the temperature regime to mechanical pressure and high frequency oscillations over time is a complex process depending on the functionality of the control elements.

One of the most popular technologies for the production of MEMS elements is the formation of structural elements, which involves the gradual use of lithography, electroplating and micro-casting processes (Lin C H and Chen R 2006 Ultrasonic nanoimprint lithography: a new approach to nanopatterning J. Microlithgraphy, Microfabrication Microsyst, https://doi.org/10.1117/1.2172992).

The innovative chart for the production of MEMS elements presented in another document (Chi Hoon Lee, Phill Gu Jung, Sang Min Lee, Sang Hu Park, Bo Sung Shin, Joon-Ho Kim, Kyu-Youn Hwang, Kyoung Min Kim and Jong Soo Ko. 2010 Replication of polyethylene nano-microhierarchical structures using ultrasonic forming. Micromech. Microeng) shows the main structural and equipment elements, as well as stages for that process in the scale of time. As shown in Figure 9a of the document, the ultrasonic frequency generator excites mechanical oscillations at a frequency of about 20 kHz in an electromechanical transducer, and they are transmitted and amplified in an oscillation concentrator. The ultrasonic oscillations of the concentrator due to friction with the product in the contact zone generate relatively high energy, which makes high temperatures, which in particular is used to bond polymers or metals. This process takes place in a very short time (up to 3 s), is ecologically clean and economical. Figure 9b of the document shows the sequence of the whole process: after contact with the forming element, the clamping force of the polymer plate is increased to 690 N, and for some time it is stable and then the bonding of the surfaces takes place with the help of high-frequency oscillations. At that time, due to the friction of the surfaces, the molten polymer fills the nanostructured cavities and after some time the polymer hardens. In the specified device, the temperature required for the bonding of the surfaces is achieved due to friction excited by high-frequency oscillations between the surfaces to be bonded, which is difficult to achieve without a control system.

The closest prior art document Yafang Li et al. "High-Frequency Output Characteristics of Giant Magnetostrictive Transducer", IEEE Transactions on Magnetics (Volume: 55, Issue: 6, June 2019), DOI: 10.1109/TMAG. 2019.2910854*"* discloses a theoretical and experimental study on high-frequency (>5000 Hz) output characteristics of the giant magnetostrictive transducer (GMT) at varied operating conditions. Based on the Jiles-Atherton model, Maxwell's equations, Newton's law, and Fourier's heat transfer equation, a nonlinear electromagnetic-mechanical-thermal multi-field coupled finite element model for GMT is established. The output displacement amplitude of the magnetostrictive rod and the acceleration of vibrating horn at the GMT device are measured and analyzed at varied exciting amplitude of ac magnetic field and frequencies (from 5600 to 7000 Hz). The frequency dependences of permeability and magnetoelastic coupling coefficient obtained from the experimental results are used in revising the model parameters. These output characteristics analysis results can provide theoretical and experimental guidance in the optimization of structural design and precise controlling for high-frequency GMT system. The present invention - the system - provides more efficient control of the process of forming polymeric structures, where the temperature of the forming transducer is taken into account, to control the vibrating concentrator-sonotrode.

The invention eliminates the disadvantages of the prior arts - it solves the temperature regime coordination with the moment of pressure on the material to be formed and the high frequency oscillations with respect of time.

### SUMMARY OF THE INVENTION

The invention is a system for forming microstructures in polymeric materials, comprising an electromechanical transducer - a magnetostrictive vibrator, a sonotrode, a generator, a clamping mechanism, and a tray with the material to be formed. The presented system generates high frequency oscillations in a magnetostrictive vibrator consisting of a magnetostrictor with a core on which two windings are wound: one for achieving the magnetization level of the magnetostrictor, and the other for excitation of the high frequency oscillations in the magnetostrictor. The magnetostrictor consists of a rectangular U-shaped magnetic conductor assembled from multilayer plates of metal (nickel, permalloy, or similar materials) whose U-shaped open edge is rigidly connected to a sonotrode made of bulk ferromagnetic-magnetostrictive metal. The magnetostrictor with windings is housed in a sealed housing in which the coolant circulates. The mechanical vibration concentrator-sonotrode is separated from the magnetostrictor with windings by a gasket to isolate temperature and liquid. After excitation in the magnetostrictor the high-frequency oscillations, they are transmitted to a high-frequency oscillation concentrator-sonotrode, which also heats up due to the circuital induction of the eddy currents. In this case, the vibration level of the sonotrode is being changed by an electrical signal from the magnetostrictor magnetization winding, while the sonotrode temperature is changed by a high-frequency electrical signal connected to the corresponding magnetostrictor winding. The vibration and temperature levels of the sonotrode are measured by a sensor attached to the sonotrode operating part. In this way, the operating part of the sonotrode, while vibrating and heated to set temperature, contacts the polymeric material to be formed and, according to a coordinated program, the forming process in the polymeric materials can be efficiently controlled from the single generator control unit.

### DESCRIPTION OF DRAWINGS

The invention is explained in the drawings. The accompanying diagrams and drawings form an integral part of the description of the invention and are provided as a reference to a possible embodiment of the invention, but are not intended to limit the scope of the invention.

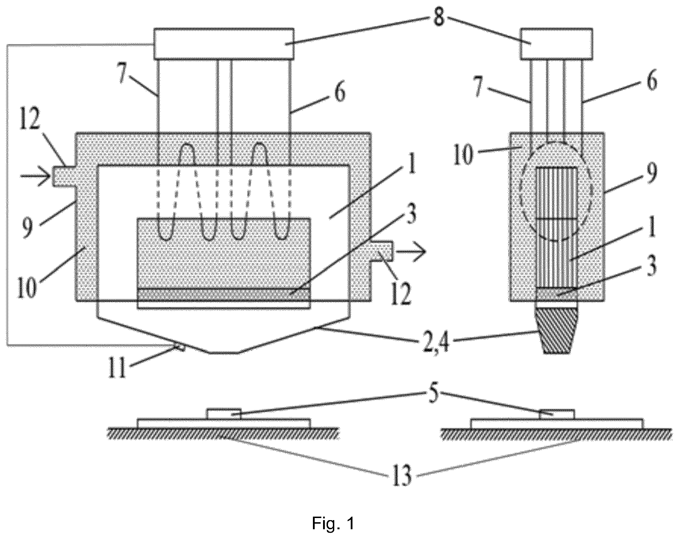

The system according to the invention and as shown in Figure 1 comprises the magnetostrictive vibrator (1) consisting of multilayer ferromagnetic plates, the operating part of which after closing the circuit of magnetic forces is rigidly attached to the mechanical vibration concentrator-sonotrode (2, 4). Between the end parts of the magnetostrictive vibrator (1) there is the gasket (3) that insulates the temperature and the liquid. The entire magnetostrictive vibrator (1) is housed in the sealed housing (9) with the coolant (10) circulating through the supply and discharge pipes (12). The magnetic conductor plates of the magnetostrictive vibrator are wound with windings (6) and (7) comprising terminals which, like the signal from the temperature and vibration sensor (11) on the mechanical vibration concentrator (2, 4), are connected to the excitation and control generator (8). The operating part of the mechanical vibration concentrator-sonotrode (2, 4) performs the forming procedure by applying pressure to the polymeric material (5) on the tray (13).

### DETAILED DESCRIPTION OF THE INVENTION

The system for forming microstructures in polymeric materials shown in Figure 1 comprises the electromechanical transducer (vibrator) (1) consisting of a U-shaped rectangular ferromagnetic-magnetostrictive plates wound with windings (6) and (7) with free ends rigidly connected to the vibration concentrator-sonotrode (2, 4). One of the windings (6) is for the DC component generating the DC electromagnetic field necessary to control the amplitude of the mechanical oscillations, and the other winding (7) is for generating the high frequency AC electromagnetic field in the magnetostrictor and controlling the concentrator-sonotrode (2, 4) temperature which may rise due to circuital currents being excited therein. In the process of forming microstructures in polymeric materials, the electrical signal is applied from the generator of vibration excitation and controller (8) to one of the windings (6) that is intended to generate the DC electromagnetic field and control the amplitude of the mechanical vibrations, and the electrical signal is applied to the other winding (7) that is intended to generate the AC electromagnetic field and to control the temperature of the concentrator-sonotrode (2, 4). The electromagnetic field generated by the AC and DC windings (6, 7) in the ferromagnetic-magnetostrictive plates causes mechanical vibrations, which are transmitted to the vibration concentrator-sonotrode (2, 4) rigidly connected to the free ends of the magnetostrictive vibrator (1). The entire magnetostrictive vibrator (1) is housed in a sealed housing (9) with coolant (10) circulating therein through the liquid supply and discharge pipes (12), thereby protecting the magnetostrictive vibrator (1) from overheating. The coolant (10) is separated from the vibration concentrator-sonotrode (2, 4) by the gasket (3) that insulates temperature and liquid. In order for the whole system for formation of microstructures in polymeric materials to work stably and efficiently, the temperature and vibration sensor (11) is mounted on the operating part of the vibration concentrator-sonotrode (2, 4), the signal from this sensor being fed back to the excitation and control generator (8).

This comprehensive and timely effect of high-frequency vibration excitation and increased temperature and pressure on the formed polymeric structure allows to increase the efficiency of the whole process and the quality of the structural elements.

## Claims

1. A system for forming microstructures in polymeric materials comprising an electromechanical transducer (1), a vibration excitation and control generator (8), and a high-frequency vibration concentrator-sonotrode (2), wherein the electromechanical transducer (1) comprises a rectangular U-shaped conductor comprising rectangular U-shaped ferromagnetic magnetostrictive plates wound with windings (6, 7), the free ends of which are rigidly connected to a vibration concentrator-sonotrode (2)
**characterised in that** the vibration concentrator-sonotrode (2) is made of a bulk ferromagnetic-magnetostrictive metal, and that in the electromechanical transducer (1), a winding (7) powered by a high-frequency AC electrical signal from the vibration excitation and control generator (8) is used to control the temperature of the vibration concentrator-sonotrode (2).

2. The system according to Claim 1, **characterized in that** the winding (6) supplied with a DC electrical signal from the vibration excitation and control generator (8) is used in the electromechanical transducer (1) to control the vibration amplitude of the vibration concentrator-sonotrode (2)

3. The system according to Claim 1, **characterized in that** the vibration and temperature sensor (11) is attached to the operating part of the vibration concentrator-sonotrode (2), which is connected as feedback to the excitation and control generator (8).

4. System according to Claim 1, **characterized in that** a liquid-insulating gasket (3) is installed between the electromechanical transducer (1) and the vibration concentrator-sonotrode (2).

## Patentansprüche

1. System zum Bilden von Mikrostrukturen in polymeren Materialien, umfassend einen elektromechanischen Wandler (1), einen Vibrationsanregungs- und Steuergenerator (8) und eine Hochfrequenz-Vibrationskonzentrator-Sonotrode (2), wobei der elektromechanische Wandler (1) einen rechteckigen U-förmigen Leiter umfasst, der rechteckige U-förmige ferromagnetische magnetostriktive Platten umfasst, die mit Wicklungen (6, 7) gewickelt sind, deren freie Enden starr mit einer Vibrationskonzentrator-Sonotrode (2) verbunden sind, **dadurch gekennzeichnet, dass** die Vibrationskonzentrator-Sonotrode (2) aus einem ferromagnetisch-magnetostriktiven Massenmetall gefertigt ist und dass in dem elektromechanischen Wandler (1) eine Wicklung (7), die durch ein elektrisches Hochfrequenz-Wechselstromsignal von dem Vibrationsanregungs- und Steuergenerator (8) angetrieben wird, verwendet wird, um die Temperatur der Vibrationskonzentrator-Sonotrode (2) zu steuern.

2. System nach Anspruch 1, **dadurch gekennzeichnet, dass** die Wicklung (6), der ein elektrisches Gleichstromsignal von dem Vibrationsanregungs- und Steuergenerator (8) zugeführt wird, in dem elektromechanischen Wandler (1) verwendet wird, um die Vibrationsamplitude der Vibrationskonzentrator-Sonotrode (2) zu steuern.

3. System nach Anspruch 1, **dadurch gekennzeichnet, dass** der Vibrations- und Temperatursensor (11) an dem Betriebsteil der Vibrationskonzentrator-Sonotrode (2) angebracht ist, der als Rückkopplung mit dem Anregungs- und Steuergenerator (8) verbunden ist.

4. System nach Anspruch 1, **dadurch gekennzeichnet, dass** eine flüssigkeitsisolierende Dichtung (3) zwischen dem elektromechanischen Wandler (1) und der Vibrationskonzentrator-Sonotrode (2) installiert ist.

## Revendications

1. Système pour la formation de microstructures dans des matériaux polymères comprenant un transducteur électromécanique (1), un générateur d'excitation et de commande de vibrations (8) et un concentrateur-sonotrode de vibrations haute fréquence (2), dans lequel le transducteur électromécanique (1) comprend un conducteur rectangulaire en forme de U comprenant des plaques magnétostrictives ferromagnétiques rectangulaires en forme de U enroulées avec des enroulements (6, 7) dont les extrémités libres sont reliées d'une manière rigide à un concentrateur-sonotrode de vibrations (2) **caractérisé en ce que** le concentrateur-sonotrode de vibrations (2) est réalisé à partir d'un métal ferromagnétique-magnétostrictif en vrac,
et **en ce que** dans le transducteur électromécanique (1), un enroulement (7) alimenté par un signal électrique alternatif haute fréquence provenant du générateur d'excitation et de commande de vibrations (8) est utilisé pour commander la température du concentrateur-sonotrode de vibrations (2).

2. Système selon la revendication 1, **caractérisé en ce que** l'enroulement (6) alimenté par un signal électrique continu provenant du générateur d'excitation et de commande de vibrations (8) est utilisé dans le transducteur électromécanique (1) pour commander l'amplitude des vibrations du concentrateur-sonotrode de vibrations (2).

3. Système selon la revendication 1, **caractérisé en ce que** le capteur de vibrations et de température (11) est fixé à la partie fonctionnelle du concentrateur-sonotrode de vibrations (2), qui est reliée en retour au générateur d'excitation et de commande (8).

4. Système selon la revendication 1, **caractérisé en ce qu'**un joint isolant les liquides (3) est installé entre le transducteur électromécanique (1) et le concentrateur-sonotrode de vibrations (2).
